# EUROPEAN PATENT APPLICATION

(11) **EP 3 901 226 A1**
(43) Date of publication of application: **27.10.2021**
(21) Application number: 20170636.3
(22) Date of filing: 21.04.2020
(51) Int. Cl.: C09D 11/101, C09D 11/38, H05K 1/00

(54) **METHOD OF MANUFACTURING PRINTED CIRCUIT BOARDS**

(71) Applicant: AGFA-GEVAERT NV, 2640 Mortsel (BE)
(72) Inventor: UYTTENDAELE, Carlo, 2640 Mortsel (BE); SAUVAGEOT, Marion, 2640 Mortsel (BE); MASQUELET, Lucie, 2640 Mortsel (BE); LOCCUFIER, Johan, 2640 Mortsel (BE)
(74) Representative: Viaene, Kris

(57) **Abstract**

A method of manufacturing a Printed Circuit Board (PCB) including an inkjet printing step wherein a radiation curable inkjet ink comprising at least one polymerizable compound and at least one photoinitiator is jetted and cured on a substrate, characterized in that the at least one photoinitiator has a chemical structure according to Formula I, 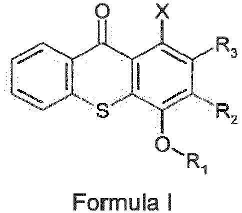 wherein
X represents a halogen;
R1 is selected from the group consisting of a substituted or unsubstituted alkyl group, a substituted and unsubstituted alkenyl group, a substituted or unsubstituted alkynyl group, a substituted or unsubstituted aralkyl group, a substituted or unsubstituted alkaryl group and a substituted or unsubstituted aryl or heteroaryl group;
R2 and R3 are independently from each other selected from the group consisting of a hydrogen, a substituted or unsubstituted alkyl group, a substituted or unsubstitited alkoxy group, a substituted or unsubstituted aryloxy group and a halogen;
R1 together with R2 and R2 together with R3 may represent the necessary atoms to form a five to eight membered ring.

## Description

### Technical field of the Invention

The present invention relates to a method of manufacturing Printed Circuit Boards including an inkjet printing step and to inkjet inks used therein.

### Background art for the invention

The production workflow of printed circuit boards (PCBs) is gradually shifting from the standard workflow towards a digital workflow to reduce the amount of process steps and lowering the cost and the environmental impact, especially for short run productions.

Inkjet printing is a preferred digital manufacturing technology for different steps of the PCB manufacturing process, going from etch resist over solder mask to legend printing. Preferred inkjet inks are UV curable ink jet inks.

In the different production steps of PCBs, adhesion of the inkjet inks towards various substrates is of crucial importance. When the radiation curable inkjet ink is used to produce a solder mask, the adhesion of the cured inkjet ink on several substrates has to survive the severe conditions used during soldering (solder resistance) and ENIG plating (ENIG plating resistance). Especially the ENIG plating process wherein severe and varying conditions (pH and temperature) are used is very demanding as regard to the adhesion requirements of the inkjet ink.

To improve the adhesion, so-called adhesion promoters have been added to the inkjet inks. For example in WO2004/026977 and WO2004/105 (Avecia) (meth)acrylate functional monomers containing one or more acid groups, such as (meth)acrylated carboxylic acids, (meth)acrylated phosphoric acid esters and (meth)acrylated sulphonic acids have been proposed to improve the adhesion. EP-A 3119170 (Agfa Gevaert) discloses radiation curable inkjet inks used in PCB manufacturing comprising a silane compound as adhesion promoter.

However, there is still a need for inkjet inks that can be used in a PCB manufacturing process having an improved ENIG plating resistance.

### Summary of the invention

It is an object of the invention to provide a method of manufacturing a printed circuit board (PCB) including an inkjet printing step to prepare a solder mask wherein the solder mask has an improved ENIG resistance.

The object of the invention is realized by the method of manufacturing a printed circuit board (PCB) as defined in claim 1.

Further objects of the invention will become apparent from the description hereinafter.

### Detailed description of the invention

### Definitions

The term "monofunctional" in e.g. monofunctional polymerizable compound means that the polymerizable compound includes one polymerizable group.

The term "difunctional" in e.g. difunctional polymerizable compound means that the polymerizable compound includes two polymerizable groups.

The term "polyfunctional" in e.g. polyfunctional polymerizable compound means that the polymerizable compound includes more than two polymerizable groups.

The term "alkyl" means all variants possible for each number of carbon atoms in the alkyl group i.e. methyl, ethyl, for three carbon atoms: n-propyl and isopropyl; for four carbon atoms: n-butyl, isobutyl and tertiary-butyl; for five carbon atoms: n-pentyl, 1,1-dimethyl-propyl, 2,2-dimethylpropyl and 2-methyl-butyl, etc.

Unless otherwise specified a substituted or unsubstituted alkyl group is preferably a C₁ to C₆-alkyl group.

Unless otherwise specified a substituted or unsubstituted alkenyl group is preferably a C₂ to C₆-alkenyl group.

Unless otherwise specified a substituted or unsubstituted alkynyl group is preferably a C₂ to C₆-alkynyl group.

Unless otherwise specified a substituted or unsubstituted alkaryl group is preferably a phenyl or naphthyl group including one, two, three or more C₁ to C₆-alkyl groups.

Unless otherwise specified a substituted or unsubstituted aralkyl group is preferably a C₇ to C₂₀-alkyl group including a phenyl group or naphthyl group.

Unless otherwise specified a substituted or unsubstituted aryl group is preferably a phenyl group or naphthyl group
Unless otherwise specified a substituted or unsubstituted heteroaryl group is preferably a five- or six-membered ring substituted by one, two or three oxygen atoms, nitrogen atoms, sulphur atoms, selenium atoms or combinations thereof.

The term "substituted", in e.g. substituted alkyl group means that the alkyl group may be substituted by other atoms than the atoms normally present in such a group, i.e. carbon and hydrogen. For example, a substituted alkyl group may include a halogen atom or a thiol group. An unsubstituted alkyl group contains only carbon and hydrogen atoms

Unless otherwise specified a substituted alkyl group, a substituted alkenyl group, a substituted alkynyl group, a substituted aralkyl group, a substituted alkaryl group, a substituted aryl and a substituted heteroaryl group are preferably substituted by one or more constituents selected from the group consisting of methyl, ethyl, n-propyl, isopropyl, n-butyl, isobutyl and tertiary-butyl, ester, amide, ether, thioether, ketone, aldehyde, sulfoxide, sulfone, sulfonate ester, sulphonamide, -Cl, -Br, -I, -OH, -SH, - CN and -NO₂.

### Method of manufacturing a printed circuit board

The method of manufacturing a Printed Circuit Board (PCB) according to the present invention includes at least one inkjet printing step wherein a radiation curable inkjet ink as described below is jetted and cured on a substrate.

According to a preferred embodiment, the method of manufacturing a PCB comprises an inkjet printing step wherein a solder mask is provided.

The solder mask is provided by jetting and curing the radiation curable inkjet ink typically on a dielectric substrate containing an electrically conductive pattern.

A heat treatment is preferably applied to the jetted and cured radiation curable inkjet ink. The heat treatment is preferably carried out at a temperature between 80°C and 250°C. The temperature is preferably not less than 100°C, more preferably not less than 120°C. To prevent charring of the solder mask, the temperature is preferably not higher than 200°C, more preferably not higher than 160°C.

The thermal treatment is typically carried out between 15 and 90 minutes.

The purpose of the thermal treatment is to further increase the polymerization degree of the solder mask.

The dielectric substrate of the electronic device may be any non-conductive material. The substrate is typically a paper/resin composite or a resin/fibre glass composite, a ceramic substrate, a polyester or a polyimide.

The electrically conductive pattern is typically made from any metal or alloy which is conventionally used for preparing electronic devices such as gold, silver, palladium, nickel/gold, nickel, tin, tin/lead, aluminium, tin/aluminium and copper. The electrically conductive pattern is preferably made from copper.

The radiation curable inkjet ink may be cured by exposing the ink to actinic radiation, such as electron beam or ultraviolet (UV) radiation. Preferably the radiation curable inkjet ink is cured by UV radiation, more preferably using UV LED curing.

The method of manufacturing a PCB may comprise two, three or more inkjet printing steps. For example the method may comprise two inkjet printing steps wherein an etch resist is provided on a metal surface in one inkjet printing step and wherein a solder mask is provided on a dielectric substrate containing an electrically conductive pattern in another inkjet printing step.

A third inkjet printing step may be used for legend printing.

### Radiation Curable Inkjet Ink

The radiation curable inkjet ink comprises at least one polymerizable compound and a photoinitiator as described below.

The radiation curable inkjet ink may further comprise other ingredients such as an adhesion promoter, a colorant, a polymeric dispersant, a polymerization inhibitor, a flame retardant or a surfactant.

The radiation curable inkjet ink may be cured with any type of radiation but is preferably cured with UV radiation, more preferably with UV radiation from UV LEDs. The radiation curable inkjet ink is thus preferably a UV curable inkjet ink.

For reliable industrial inkjet printing, the viscosity of the radiation curable inkjet ink is preferably no more than 20 mPa.s at 45°C, more preferably between 1 and 18 mPa.s at 45°C, and most preferably between 4 and 14 mPa.s at 45°C, all at a shear rate of 1000 s⁻¹.

A preferred jetting temperature is between 10 and 70°C, more preferably between 20 and 55°C, and most preferably between 25 and 50°C.

For good image quality and adhesion, the surface tension of the radiation curable inkjet ink is preferably in the range of 18 to 70 mN/m at 25°C, more preferably in the range of 20 to 40 mN/m at 25°C.

### Photoinitiators

The radiation curable inkjet contains at least one photoinitiator according to Formula I, 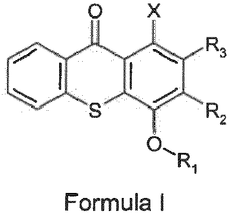 wherein
X represents a halogen;
R₁ is selected from the group consisting of a substituted or unsubstituted alkyl group, a substituted or unsubstituted alkenyl group, a substituted or unsubstituted alkynyl group, a substituted or unsubstituted aralkyl group, a substituted or unsubstituted alkaryl group and a substituted or unsubstituted aryl or heteroaryl group;
R₂ and R₃ are independently selected from the group consisting of a hydrogen, a substituted or unsubstituted alkyl group, a substituted or unsubstitited alkoxy group, a substituted or unsubstituted aryloxy group and a halogen;
R1 together with R₂ and R₂ together with R₃ may represent the necessary atoms to form a five to eight membered ring.

X preferably represents a chlorine atom or a fluorine atom, most preferably a chlorine atom.

R₂ and R₃ preferably represent independently from each other a hydrogen or a halogen, most preferably a hydrogen.

R₁ preferably represents a substituted or unsubstituted alkyl group, more preferably an unsubstituted alkyl group, most preferably a C₁ to C₆ aliphatic group.

According to a preferred embodiment, the photoinitiator according to Formula I is a polymeric or oligomeric photoinitiator wherein the R1 group is coupled to a polymeric or oligomeric moiety.

Preferred polymeric or oligomeric photoinitiators are poly(ether) derivatives.

Typical poly(ethers) are selected from the group consisting of poly(ethylene oxide), polypropylene oxide), copolymers thereof, and poly(tetrahydrofuran). Preferred polyethers are selected from the group consisting of ethoxylated or propoxylated neopentyl glycol, ethoxylated or propoxylated trimethylpropane and ethoxylated or propoxylated pentaerythritol.

The photoinitiator according to the present invention is preferably prepared by end group functionalization of the poly(ether), most preferably by esterification of the hydroxyl end groups.

Examples of photoinitiators according to Formula I are shown in Table 1.

**Table 1**

| | |
|---|---|
| 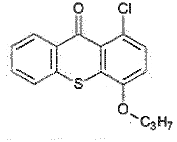 | THX-1 |
| 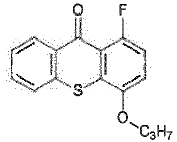 | THX-2 |
| 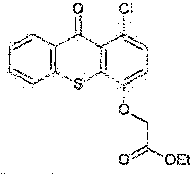 | THX-3 |
| 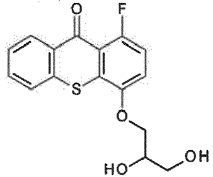 | THX-4 |
| 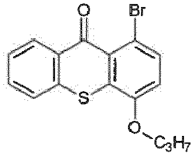 | THX-5 |
| 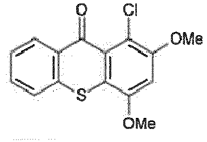 | THX-6 |
| 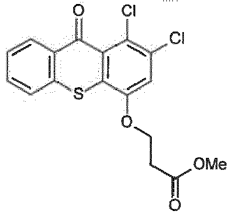 | THX-7 |
| 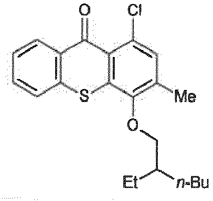 | THX-8 |
| 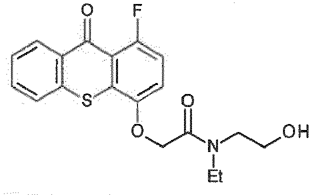 | THX-9 |
| 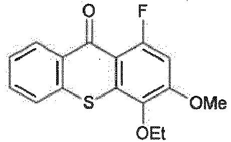 | THX-10 |
| 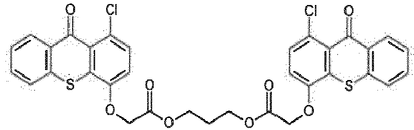 | THX-11 |
| 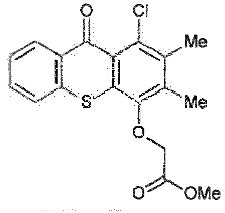 | THX-12 |
| 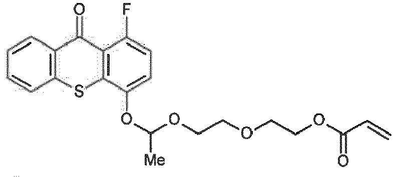 | THX-13 |
| 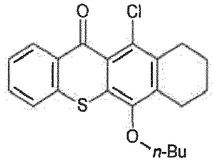 | THX-14 |
| 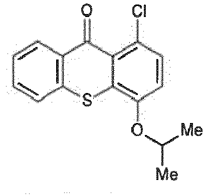 | THX-15 |

The radiation curable inkjet ink may in addition to the photoinitiator described above include one or more other photoinitiators, preferably free radical photoinitiators.

A free radical photoinitiator is a chemical compound that initiates polymerization of monomers and oligomers when exposed to actinic radiation by the formation of a free radical. A Norrish Type I initiator is an initiator which cleaves after excitation, yielding the initiating radical immediately. A Norrish type II initiator is a photoinitiator which is activated by actinic radiation and forms free radicals by hydrogen abstraction from a second compound that becomes the actual initiating free radical. This second compound is called a polymerization synergist or co-initiator. Both type I and type II photoinitiators can be used in the present invention, alone or in combination.

Suitable photoinitiators are disclosed in CRIVELLO, J.V., et al. Photoinitiators for Free Radical, Cationic and Anionic Photopolymerization. 2nd edition. Edited by BRADLEY, G.. London, UK: John Wiley and Sons Ltd, 1998. p.276-293.

Specific examples of free radical photoinitiators may include, but are not limited to, the following compounds or combinations thereof: benzophenone and substituted benzophenones; 1-hydroxycyclohexyl phenyl ketone; thioxanthones such as isopropylthioxanthone; 2-hydroxy-2-methyl-1-phenylpropan-1-one;2-benzyl-2-dimethylamino- (4-morpholinophenyl) butan-1-one; benzyl dimethylketal; bis (2,6-dimethylbenzoyl)-2,4,4-trimethylpentylphosphine oxide; 2,4,6 trimethylbenzoyldiphenylphosphine oxide; 2,4,6-trimethoxybenzoyldiphenylphosphine oxide; 2-methyl-1- [4- (methylthio) phenyl] -2-morpholinopropan-1-one; 2,2-dimethoxy-1, 2-diphenylethan-1-one or 5,7-diiodo-3- butoxy-6-fluorone.

A preferred amount of the photoinitiator according to Formula I is from 0.2 up to 20 wt%, more preferably from 0.5 up to 10 wt%, most preferably from 1 up to 8 wt%, particularly preferred from 1.5 up to 6 wt%, all relative to the total weight of the radiation curable inkjet ink.

In order to increase the photosensitivity further, the radiation curable inkjet ink may additionally contain co-initiators. Suitable examples of co-initiators can be categorized in three groups:
(1) tertiary aliphatic amines such as methyldiethanolamine, dimethylethanolamine, triethanolamine, triethylamine and N-methylmorpholine;
(2) aromatic amines such as amylparadimethyl-aminobenzoate, 2-n-butoxyethyl-4-(dimethylamino) benzoate, 2-(dimethylamino)-ethylbenzoate, ethyl-4-(dimethyl-amino)benzoate, and 2-ethylhexyl-4-(dimethylamino)benzoate; and
(3) (meth)acrylated amines such as dialkylamino alkyl(meth)acrylates (e.g., diethyl-aminoethylacrylate) or N-morpholinoalkyl-(meth)acrylates (e.g., N-morpholinoethyl-acrylate).

Preferred co-initiators are aminobenzoates.

A preferred low molecular aminobenzoate is Genocure® EPD from RAHN.

Particularly preferred aminobenzoate co-initiators are selected from the group consisting of polymerisable, oligomeric and polymeric aminobenzoate co-initiators.

Polymerisable co-initiators are disclosed in EP-A 2033949 (Agfa Graphics N.V.).

In a more preferred embodiment, the aminobenzoate co-initiators are oligomeric aminobenzoate derivatives.

Particularly preferred aminobenzoates are polyether derivatives of aminobenzoates, wherein the polyether is selected from the group consisting of poly(ethylene oxide), polypropylene oxide), copolymers thereof, and poly(tetrahydrofuran), ethoxylated or propoxylated neopentyl glycol, ethoxylated or propoxylated trimethylpropane and ethoxylated or propoxylated pentaerythritol.

Preferred oligomeric aminobenzoates are disclosed in WO1996/33157 (Lambson Fine Chemicals Ltd.) and WO2011/030089 (Sun Chemicals B.V.). Typical examples of polyethylene glycol bis p-dimethylaminobenzoate are OMNIPOL ASA, commercially available from IGM Resins and Speedcure® 7040, commercially available from Lambson Fine Chemicals.

Other oligomeric or polymeric co-initiators are for example ESACURE A198, a polyfunctional amine from IGM and SARTOMER® CN3755, an acrylated amine co-initiator from ARKEMA.

### Polymerizable Compounds

The polymerizable compounds are preferably free radical polymerizable compounds.

The free radical polymerizable compounds may be monomers, oligomers and/or prepolymers. Monomers are also referred to as diluents.

These monomers, oligomers and/or prepolymers may possess different degrees of functionality, i.e. a different amount of free radical polymerizable groups.

A mixture including combinations of mono-, di-, tri-and higher functional monomers, oligomers and/or prepolymers may be used. The viscosity of the radiation curable inkjet ink may be adjusted by varying the ratio between the monomers and oligomers.

In a preferred embodiment, the monomer, oligomer or polymer includes at least one acrylate group as polymerizable group.

Preferred monomers and oligomers are those listed in paragraphs [0106] to [0115] in EP-A 1911814.

In a preferred embodiment, the radiation curable inkjet ink comprises a monomer containing a vinyl ether group and an acrylate or methacrylate group. Such monomers are disclosed in EP-A 2848659, paragraphs [0099] to [0104]). A particular preferred monomer containing a vinyl ether group and an acrylate group is 2-(2-vinyloxyethoxy)ethyl acrylate.

The polymerizable compound is preferably selected from the group consisting of acryloyl morpholine, cyclic trimethyl propane formol acrylate, isobornyl acrylate, lauryl acrylate, dipropylene glycol diacrylate, trimethylol propane triacrylate, 2-(vinylethoxy)ethyl acrylate and urethane acrylate.

### Adhesion promoter

The radiation curable inkjet ink preferably includes an adhesion promoter to optimize the adhesion of the cured composition to various surfaces, in particular a copper surface. Moreover, the adhesion of the cured inkjet inks to a copper surface must remain sufficient after the treatments steps typically carried out in PCB manufacturing such as soldering, gold plating or ENIG plating.

A preferred adhesion promoter is a silane compound as disclosed in EP-A 3119170 (Agfa Gevaert), paragraph [0034] to [0039]).

The radiation curable inkjet ink may include one adhesion promoter or a combination of two, three or more different adhesion promoters.

The total amount of adhesion promoters is preferably between 0.1 and 20 wt%, more preferably between 0.5 and 15 wt%, most preferably between 1 and 10 wt%, all relative to the total weight of the inkjet ink.

When the amount is too low, the adhesion of the inkjet ink may be insufficient, when the amount is too high, the ink viscosity may increase and the shelf life of the ink may become more critical.

### Phenolic compound

The radiation curable inkjet ink preferably comprises a phenolic compound, more preferably a phenolic compound comprising at least two phenolic groups, as disclosed in WO2018/087056 (Agfa Gevaert, Electra Polymers) in paragraphs [053] to [068].

The amount of phenolic compounds is preferably between 0.5 and 20 wt%, more preferably between 1 and 15 wt%, most preferably between 2.5 and 10 wt%, relative to the total weight of the inkjet ink.

### Colorants

The radiation curable inkjet may be a substantially colourless inkjet ink or may include at least one colorant. For example when the inkjet ink is used as etch resist, the colorant makes the temporary mask clearly visible to the manufacturer of conductive patterns, allowing a visual inspection of quality. When the inkjet ink is used to apply a solder mask it typically contains a colorant. A preferred colour for a solder mask is green, however other colours such as black or red may also be used.

The colorant may be a pigment or a dye.

A colour pigment may be chosen from those disclosed by HERBST, Willy, et al. Industrial Organic Pigments, Production, Properties, Applications. 3rd edition. Wiley - VCH, 2004. ISBN 3527305769. Suitable pigments are disclosed in paragraphs [0128] to [0138] of WO2008/074548.

Pigment particles in inkjet inks should be sufficiently small to permit free flow of the ink through the inkjet-printing device, especially at the ejecting nozzles. It is also desirable to use small particles for maximum colour strength and to slow down sedimentation. Most preferably, the average pigment particle size is no larger than 150 nm. The average particle size of pigment particles is preferably determined with a Brookhaven Instruments Particle Sizer BI90plus based upon the principle of dynamic light scattering.

Generally dyes exhibit a higher light fading than pigments, but cause no problems on jettability. It was found that anthraquinone dyes exhibit only minor light fading under the normal UV curing conditions used in UV curable inkjet printing. In a preferred embodiment, the colorant in the radiation curable inkjet ink is an anthraquinone dye, such as Macrolex™ Blue 3R (CASRN 325781-98-4) from LANXESS.

Other preferred dyes include crystal violet and a copper phthalocyanine dye.

In a preferred embodiment, the colorant is present in an amount of 0.5 to 6.0 wt%, more preferably 1.0 to 2.5 wt%, based on the total weight of the radiation curable inkjet ink.

### Polymeric Dispersants

If the colorant in the radiation curable inkjet is a pigment, then the radiation curable inkjet preferably contains a dispersant, more preferably a polymeric dispersant, for dispersing the pigment.

Suitable polymeric dispersants are copolymers of two monomers but they may contain three, four, five or even more monomers. The properties of polymeric dispersants depend on both the nature of the monomers and their distribution in the polymer. Copolymeric dispersants preferably have the following polymer compositions:
- statistically polymerized monomers (e.g. monomers A and B polymerized into ABBAABAB);
- alternating polymerized monomers (e.g. monomers A and B polymerized into ABABABAB);
- gradient (tapered) polymerized monomers (e.g. monomers A and B polymerized into AAABAABBABBB);
- block copolymers (e.g. monomers A and B polymerized into AAAAABBBBBB) wherein the block length of each of the blocks (2, 3, 4, 5 or even more) is important for the dispersion capability of the polymeric dispersant;
- graft copolymers (graft copolymers consist of a polymeric backbone with polymeric side chains attached to the backbone); and
- mixed forms of these polymers, e.g. blocky gradient copolymers.

Suitable polymeric dispersants are listed in the section on "Dispersants", more specifically [0064] to [0070] and [0074] to [0077], in EP-A 1911814.

Commercial examples of polymeric dispersants are the following:
- DISPERBYK™ dispersants available from BYK CHEMIE GMBH;
- SOLSPERSE™ dispersants available from NOVEON;
- TEGO™ DISPERS™ dispersants from EVONIK;
- EDAPLAN™ dispersants from MÜNZING CHEMIE;
- ETHACRYL™ dispersants from LYONDELL;
- GANEX™ dispersants from ISP;
- DISPEX™ and EFKA™ dispersants from CIBA SPECIALTY CHEMICALS INC;
- DISPONER™ dispersants from DEUCHEM; and
- JONCRYL™ dispersants from JOHNSON POLYMER.

### Polymerization Inhibitors

The radiation curable inkjet ink may contain at least one inhibitor for improving the thermal stability of the ink.

Suitable polymerization inhibitors include phenol type antioxidants, hindered amine light stabilizers, phosphor type antioxidants, hydroquinone monomethyl ether commonly used in (meth)acrylate monomers, and hydroquinone, t-butyl-catechol, pyrogallol, 2,6-di-tert.butyl-4-methylphenol (=BHT) may also be used.

Suitable commercial inhibitors are, for example, Sumilizer™ GA-80, Sumilizer™ GM and Sumilizer™ GS produced by Sumitomo Chemical Co. Ltd.; Genorad™ 16, Genorad™18 and Genorad™ 20 from Rahn AG; Irgastab™UV10 and Irgastab™ UV22, Tinuvin™ 460 and CGS20 from Ciba Specialty Chemicals; Floorstab™ UV range (UV-1, UV-2, UV-5 and UV-8) from Kromachem Ltd, Additol™ S range (S100, S110, S120 and S130) from Cytec Surface Specialties.

Since excessive addition of these polymerization inhibitors may lower the curing speed, it is preferred that the amount capable of preventing polymerization is determined prior to blending. The amount of a polymerization inhibitor is preferably lower than 5 wt%, more preferably lower than 3 wt% of the total radiation curable inkjet ink.

### Surfactants

The radiation curable inkjet ink may contain at least one surfactant.

The surfactant can be anionic, cationic, non-ionic, or zwitter-ionic and is usually added in a total quantity less than 1wt% based on the total weight of the radiation curable inkjet ink.

Suitable surfactants include fluorinated surfactants, fatty acid salts, ester salts of a higher alcohol, alkylbenzene sulfonate salts, sulfosuccinate ester salts and phosphate ester salts of a higher alcohol (for example, sodium dodecylbenzenesulfonate and sodium dioctylsulfosuccinate), ethylene oxide adducts of a higher alcohol, ethylene oxide adducts of an alkylphenol, ethylene oxide adducts of a polyhydric alcohol fatty acid ester, and acetylene glycol and ethylene oxide adducts thereof (for example, polyoxyethylene nonylphenyl ether, and SURFYNOL™ 104, 104H, 440, 465 and TG available from AIR PRODUCTS & CHEMICALS INC.).

Preferred surfactants are selected from fluoric surfactants (such as fluorinated hydrocarbons) and silicone surfactants. The silicone surfactants are preferably siloxanes and can be alkoxylated, polyether modified, polyether modified hydroxy functional, amine modified, epoxy modified and other modifications or combinations thereof. Preferred siloxanes are polymeric, for example polydimethylsiloxanes.

Preferred commercial silicone surfactants include BYK™ 333 and BYK™ UV3510 from BYK Chemie.

In a preferred embodiment, the surfactant is a polymerizable compound.

Preferred polymerizable silicone surfactants include a (meth)acrylated silicone surfactant. Most preferably the (meth)acrylated silicone surfactant is an acrylated silicone surfactant, because acrylates are more reactive than methacrylates.

In a preferred embodiment, the (meth)acrylated silicone surfactant is a polyether modified (meth)acrylated polydimethylsiloxane or a polyester modified (meth)acrylated polydimethylsiloxane.

Preferably the surfactant is present in the radiation curable inkjet ink in an amount of 0 to 3 wt% based on the total weight of the radiation curable inkjet ink.

### Flame retardant

The radiation curable inkjet ink preferably comprises a flame retardant.

Preferred flame retardants are inorganic flame retardants, such as Alumina Trihydrate and Boehmite, and organo-phosphor compounds, such as organo-phosphates (e.g. triphenyl phosphate (TPP), resorcinol bis (diphenylphosphate) (RDP), bisphenol A diphenyl phosphate (BADP), and tricresyl phosphate (TCP)); organo-phosphonates (e.g. dimethyl methylphosphonate (DMMP)); and organophosphinates (e.g. aluminium dimethylphosphinate).

Other preferred organo-phosphor compounds are disclosed in US8273805 (JNC Corporation)) and EP-A 3498788 (Agfa Gevaert).

### Preparation of Inkjet Inks

The preparation of pigmented radiation curable inkjet inks is well-known to the skilled person. Preferred methods of preparation are disclosed in paragraphs [0076] to [0085] of WO2011/069943.

### Inkjet Printing Devices

The radiation curable inkjet ink may be jetted by one or more print heads ejecting small droplets in a controlled manner through nozzles onto a substrate, which is moving relative to the print head(s).

A preferred print head for the inkjet printing system is a piezoelectric head. Piezoelectric inkjet printing is based on the movement of a piezoelectric ceramic transducer when a voltage is applied thereto. The application of a voltage changes the shape of the piezoelectric ceramic transducer in the print head creating a void, which is then filled with ink. When the voltage is again removed, the ceramic expands to its original shape, ejecting a drop of ink from the print head. However the inkjet printing method according to the present invention is not restricted to piezoelectric inkjet printing. Other inkjet print heads can be used and include various types, such as a continuous type.

The inkjet print head normally scans back and forth in a transversal direction across the moving ink-receiving surface (substrate). Often the inkjet print head does not print on the way back. Bi-directional printing is preferred for obtaining a high areal throughput. Another preferred printing method is by a "single pass printing process", which can be performed by using page wide inkjet print heads or multiple staggered inkjet print heads which cover the entire width of the ink-receiving surface. In a single pass printing process the inkjet print heads usually remain stationary and the ink-receiving surface is transported under the inkjet print heads.

### Curing Devices

The radiation curable inkjet ink can be cured by exposing them to actinic radiation, such as electron beam or ultraviolet radiation. Preferably the radiation curable inkjet ink is cured by ultraviolet radiation, more preferably using UV LED curing.

In inkjet printing, the curing means may be arranged in combination with the print head of the inkjet printer, travelling therewith so that the curable liquid is exposed to curing radiation very shortly after been jetted.

In such an arrangement, with the exception of UV LEDs, it can be difficult to provide a small enough radiation source connected to and travelling with the print head. Therefore, a static fixed radiation source may be employed, e.g. a source of curing UV-light, connected to the radiation source by means of flexible radiation conductive means such as a fibre optic bundle or an internally reflective flexible tube.

Alternatively, the actinic radiation may be supplied from a fixed source to the radiation head by an arrangement of mirrors including a mirror upon the radiation head.

The source of radiation may also be an elongated radiation source extending transversely across the substrate to be cured. It may be adjacent the transverse path of the print head so that the subsequent rows of images formed by the print head are passed, stepwise or continually, beneath that radiation source.

Any ultraviolet light source, as long as part of the emitted light can be absorbed by the photo-initiator or photo-initiator system, may be employed as a radiation source, such as, a high or low pressure mercury lamp, a cold cathode tube, a black light, an ultraviolet LED, an ultraviolet laser, and a flash light. Of these, the preferred source is one exhibiting a relatively long wavelength UV-contribution having a dominant wavelength of 300-400 nm. Specifically, a UV-A light source is preferred due to the reduced light scattering therewith resulting in more efficient interior curing.

UV radiation is generally classed as UV-A, UV-B, and UV-C as follows:
- UV-A: 400 nm to 320 nm
- UV-B: 320 nm to 290 nm
- UV-C: 290 nm to 100 nm.

In a preferred embodiment, the radiation curable inkjet ink is cured by UV LEDs. The inkjet printing device preferably contains one or more UV LEDs preferably with a wavelength larger than 360 nm, preferably one or more UV LEDs with a wavelength larger than 380 nm, and most preferably UV LEDs with a wavelength of about 395 nm.

Furthermore, it is possible to cure the ink image using, consecutively or simultaneously, two light sources of differing wavelength or illuminance. For example, the first UV-source can be selected to be rich in UV-C, in particular in the range of 260 nm-200 nm. The second UV-source can then be rich in UV-A, e.g. a gallium-doped lamp, or a different lamp high in both UV-A and UV-B. The use of two UV-sources has been found to have advantages e.g. a fast curing speed and a high curing degree.

For facilitating curing, the inkjet printing device often includes one or more oxygen depletion units. The oxygen depletion units place a blanket of nitrogen or other relatively inert gas (e.g. CO₂), with adjustable position and adjustable inert gas concentration, in order to reduce the oxygen concentration in the curing environment. Residual oxygen levels are usually maintained as low as 200 ppm, but are generally in the range of 200 ppm to 1200 ppm.

### EXAMPLES

### Materials

All materials used in the following examples were readily available from standard sources such as ALDRICH CHEMICAL Co. (Belgium) and ACROS (Belgium) unless otherwise specified. The water used was deionized water.

**ACMO** is acryloyl morpholine available from RAHN.

**VEEA** is 2-(vinylethoxy)ethyl acrylate available from NIPPON SHOKUBAI, Japan.

**SR335** is a lauryl acrylate available as Sartomer™ SR335 from ARKEMA.

**CD420** is 3,3,5-trimethylcyclohexyl acrylate available from ARKEMA.

**TMPTA** is trimethylolpropane triacrylate available as Sartomer™ SR351 from ARKEMA.

**SR531** is a cyclic trimethylolpropane formal acrylate (CTFA) available as Sartomer™ 531 from ARKEMA.

**SR595** is 1,10 decanedioldiacrylate available as Sartomer™ SR595 from ARKEMA.

**PB5** is a branched poly(4-hydroxystyrene) available as PB5 from HYDRITE CHEMICAL COMPANY.

**BAPO** is a bis(2,4,6-trimethylbenzoyl)-phenylphosphineoxide photoinitiator available as Irgacure™ 819 from BASF.

**ITX** is Speedcure™ ITX, a mixture of isopropyl thioxanthone isomers, from LAMBSON SPECIALTY CHEMICALS.

**Speedcure 7010** is a polymeric 1-chlorothioxanthone derivative available from ARKEMA.

**Omnipol ASA** is a polymeric amine synergist available from IGM Resins.

**THX-01** is 1-chloro-4-propoxythioxanthone available as Speedcure CPTX from ARKEMA.

**EPD** is aminobenzoate available as Genocure EPD from RAHN.

**AA** is acrylic acid available from Aldrich.

**SIL-1** is 3-glycidoxypropyltrimethoxy silane available as Silane Z-6040 from DOW CORNING.

**INHIB** is a mixture forming a polymerization inhibitor having a composition according to Table 4.

**Table 4**

| Component | wt% |
|---|---|
| DPGDA | 82.4 |
| p-methoxyphenol | 4.0 |
| 2,6-di-tert-butyl-4-methylphenol | 10.0 |
| Cupferron™ AL | 3.6 |

**Cupferron™ AL** is aluminum N-nitrosophenylhydroxylamine from WAKO CHEMICALS LTD.

**DPGDA** is dipropylenediacrylate, available as Sartomer SR508 from ARKEMA.

**Ebecryl 1360** is a polysiloxane hexa acrylate slip agent from ALLNEX.

**Cyan** is SUN FAST BLUE 15:4, a cyan pigment available from SUN CHEMICALS.

**Yellow** is CROMOPHTAL YELLOW D 1085J, a yellow pigment from BASF.

**Disperbyk 162** is a dispersing agent and has been precipitated from a solution available from BYK (ALTANA).

**FR01** is a flame retardant commercially available under tradename ADK Stab FP600 from ADEKA PALMAROL.

### Methods

### Viscosity

The viscosity of the inks was measured at 45°C and at a shear rate of 1000 s⁻¹ using a "Robotic Viscometer Type VISCObot" from CAMBRIDGE APPLIED SYSTEMS.

For industrial inkjet printing, the viscosity at 45°C and at a shear rate of 1000 s⁻¹ is preferably between 5.0 and 15 mPa.s. More preferably the viscosity at 45°C and at a shear rate of 1 000 s⁻¹ is less than 15 mPa.s.

### Adhesion of the inkjet inks

The adhesion was evaluated with a Tesatape™ 4104 PVC tape. The evaluation was made in accordance with a criterion described in Table 5.

**Table 5**

| **Evaluation value** | **Criterion** |
|---|---|
| **0** | Nothing removed, perfect adhesion. |
| **1** | Detachment of only very small parts of the cured layer, almost perfect adhesion. |
| **2** | Minor parts of the cured layer was removed by the tape, good adhesion |
| **3** | Parts of the cured layer were removed by the tape, poor adhesion. |
| **4** | Most of the cured layer was removed by the tape, poor adhesion. |
| **5** | The cured layer was completely removed from the substrate by the tape, no adhesion. |

### ENIG Resistance

First of all, the boards were dipped in a bath of acid cleaner (Umicore cleaner 865) at 40 °C during 4 min. The boards were then removed and dipped in a rinsing bath of deionized water (DW) at room temperature (RT) during 90 s.

Secondly the boards were dipped in a microetching bath comprising 8.5 wt% Na2S208 and ± 3.2 wt% H2S04 (98 %) in water at a temperature between 26-33 °C for 100 s. The boards were then removed and dipped in a rinsing bath of DW at RT during 90 s.

Thirdly the boards were dipped in a palladium activator bath (Accemulta MKN 4) at a temperature around 30 °C for 90 s. The boards were then removed and dipped in a rinsing bath of DW at RT during 90s.

Then the boards were dipped in a nickel bath (Nimuden NPR 4) at a temperature around 85 °C for 35 min. The boards were then removed and dipped in a rinsing bath of DW at RT during 90 s.

Finally, the boards were dipped in a gold bath (Gobright TAM 55) at a temperature around 80 °C for 12 min. The boards were then removed and dipped in a rinsing bath of DW at RT during 90 s.

The adhesion of the solder mask inkjet inks was then evaluated as described above.

### Example 1

This example illustrates that an UV curable inkjet ink according to the present invention may be used as a solder mask inkjet ink combining a good adhesion towards copper and a sufficient solder and ENIG resistance.

### Preparation Green pigment dispersion GPD

A concentrated Green pigment dispersions, GPD, was prepared having a composition according to Table 6.

**Table 6**

| GPD | wt% |
|---|---|
| Cyan | 7.5 |
| Yellow | 7.5 |
| Disperbyk 162 | 15 |
| INHIB | 1 |
| VEEA | 69 |

GPD was prepared as follows: 138 g of 2-(2-vinyloxyethoxy)ethyl acrylate, 2 g of a solution containing 4 wt% of 4-methoxyphenol, 10 wt% of 2,6-di-tert-butyl-4-methylphenol and 3,6 wt% of Aluminum-N-nitroso phenylhydroxyl amine in dipropylene glycol diacrylate and 30 g of Cyan and 30 g of Yellow were mixed using a DISPERLUX™ dispenser. Stirring was continued for 30 minutes. The vessel was connected to a NETZCH MiniZeta mill filled with 900 g of 0.4 mm yttrium stabilized zirconia beads ("high wear resistant zirconia grinding media" from TOSOH Co.). The mixture was circulated over the mill over 120 minutes (residence time of 45 minutes) and a rotation speed in the mill of about 10.4 m/s. During the complete milling procedure the content in the mill was cooled to keep the temperature below 60°C. After milling, the dispersion was discharged into a vessel.

### Preparation of comparative inks COMP-1 and COMP-2 and inventive inks INV-1 and INV-2

The comparative radiation curable inkjet ink COMP-1 and COMP-2 and the inventive radiation curable inkjet inks INV-1 and INV-2 were prepared according to Table 7. The weight percentages (wt%) are all based on the total weight of the radiation curable inkjet ink.

**Table 7**

| **wt% of component** | **COMP-1** | **INV-01** | **COMP-2** | **INV-2** |
|---|---|---|---|---|
| **GPD** | 6.6 | = | = | = |
| **VEEA** | 34.4 | = | 24.2 | 22.4 |
| **SR335** | 5.0 | = | = | = |
| **ACMO** | 5.0 | = | = | = |
| **CD420** | - | - | 15.0 | = |
| **TMPTA** | 5.0 | = | = | = |
| **SR531** | 8.0 | = | 20.0 | = |
| **SR595** | 16.0 | = | - | - |
| **PB5** | 3.0 | = | 5.0 | = |
| **BAPO** | 2.0 | = | = | = |
| **ITX** | 6.0 | - | 4.0 | - |
| **THX-01** | - | 6.0 | - | 6.0 |
| **EPD** | - | - | 4.0 | = |
| **Omnipol ASA** | 4.0 | = | - | - |
| **SIL-1** | 2.0 | = | - | - |
| **AA** | - | - | 1.2 | 1.0 |
| **FR-01** | 2.0 | = | = | = |
| **Ebecryl 1360** | 0.1 | = | = | = |
| **INHIB** | 0.9 | = | = | = |

The comparative samples COMP-01 and COMP-02 and the inventive samples INV-1 and INV-02 were obtained by jetting the inks using a Craftpix CPS (Printhead Konica Minolta KM1024iS, UV LED 395 12 W) on a Copper Clad Laminate (CCL) to obtain a soldermask layer having a final thickness of +/- 22 µm. The CCL includes a 35 µm copper foil that was roughened by chemical etching. In the chemical etching step the copper foil was transported through a Bungard Sprint 3000 Conveyorized Spray Etch machine at a speed of 0.4 m/min while spraying with the chemical etchant CZ2001 (available from MEC) heated at 30°C. After a rinsing step with demineralized water an extra spraying step with 1M HCL was carried out, followed again by a rinsing step with demineralized water. The copper foil was dried in an Air 2000 dryer (available from Bungard). The copper substrate was printed within 24 h after this pretreatment.
After printing the samples were baked in an oven at 150°C for 1 hour.

The ENIG resistance of the inks were tested as described above. The results are shown in Table 8.

**Table 8**

| **UV curable ink jet ink** | **ENIG Resistance** |
|---|---|
| **COMP-1** | 3 |
| **INV-01** | 2 |
| **COMP-2** | 4 |
| **INV-02** | 2 |

It is clear from the results of Table 8 that the inventive solder mask inkjet inks containing a photoinitiator according to Formula I have a better ENIG resistance.

## Claims

1. A method of manufacturing a Printed Circuit Board (PCB) including an inkjet printing step wherein a radiation curable inkjet ink comprising at least one polymerizable compound and at least one photoinitiator is jetted and cured on a substrate, **characterized in that** the at least one photoinitiator has a chemical structure according to Formula I, 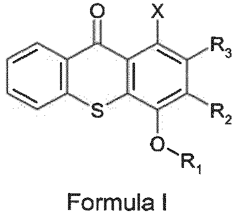 wherein
X represents a halogen;
R₁ is selected from the group consisting of a substituted or unsubstituted alkyl group, a substituted or unsubstituted alkenyl group, a substituted or unsubstituted alkynyl group, a substituted or unsubstituted aralkyl group, a substituted or unsubstituted alkaryl group and a substituted or unsubstituted aryl or heteroaryl group;
R₂ and R₃ are independently from each other selected from the group consisting of a hydrogen, a substituted or unsubstituted alkyl group, a substituted or unsubstitited alkoxy group, a substituted or unsubstituted aryloxy group and a halogen;
R₁ together with R₂ and R₂ together with R₃ may represent the necessary atoms to form a five to eight membered ring.

2. The method according to claim 1 wherein X represents a chlorine atom.

3. The method according to claim 1 or 2 wherein R₂ and R₃ independently from each other represent a hydrogen or a halogen.

4. The method according to any of the preceding claims wherein R₁ represents a substituted or unsubstituted C₁ to C₆ aliphatic alkyl group.

5. The method according to any of the preceding claim wherein the radiation curable inkjet ink further includes an adhesion promoter.

6. The method according to claim 5 wherein the adhesion promotor is a silane compound.

7. The method according to claim 5 or 6 wherein the amount of the adhesion promoter is from 1 wt% up to 10 wt% relative to the total weight of the radiation curable inkjet ink.

8. The method according according to any of the preceding claims wherein the polymerizable compound is selected from the group consisting of acryloyl morpholine, cyclic trimethyl propane formol acrylate, isobornyl acrylate, dipropylene glycol diacrylate, trimethylol propane triacrylate and 2-(vinylethoxy)ethyl acrylate.

9. The method according according to any of the preceding claims wherein the radiation curable inkjet ink further comprises a phenolic resin or a hydroxystyrene based resin.

10. The method according to any of the preceding claims wherein the radiation curable inkjet ink further comprises a colorant.

11. The method according to any of the preceding claims wherein the radiation curable inkjet ink further comprises a flame retardant.

12. The method according to any of the preceding claims wherein curing is carried out using UV radiation.

13. The method according to any of the preceding claims wherein a solder mask is provided in the inkjet printing step

14. The method according to any of the preceding claims also comprising a heating step.

15. The method according to any of the preceding claims wherein the substrate is a dielectric substrate containing an electrically conductive pattern.
